# FASCICULE DE BREVET EUROPEEN

(11) **EP 1 677 117 B1**
(45) Date de publication et mention de la délivrance du brevet: **05.10.2011**
(21) Numéro de dépôt: 05113007.8
(22) Date de dépôt: 27.12.2005
(51) Int. Cl.: G01P 15/125, G01P 15/08, B81B 3/00

(54) **Accéléromètre micro-usine à peignes capacitifs**
Mikromechanischer Beschleunigungsaufnehmer mit kapazitiven Kammstrukturen
Micromachined accelerometer with capacitive comb structures

(30) Priorité: 29.12.2004 FR 0414033
(43) Date de publication de la demande: 05.07.2006
(73) Titulaire: Commissariat à l'Énergie Atomique et aux Énergies Alternatives, 75015 Paris (FR)
(72) Inventeur: Robert, Philippe, 38100, GRENOBLE (FR)
(74) Mandataire: Poulin, Gérard

(56) Documents cités:
- DE-A1- 19 928 291
- PATENT ABSTRACTS OF JAPAN vol. 1998, no. 05, 30 avril 1998 (1998-04-30) -& JP 10 002911 A (HITACHI LTD; HITACHI CAR ENG CO LTD), 6 janvier 1998 (1998-01-06)

## Description

### DOMAINE TECHNIQUE

L'invention se situe dans le domaine des micro-capteurs silicium et concerne plus spécifiquement un accéléromètre micro-usiné à peignes capacitifs comportant un substrat, une électrode mobile par rapport audit substrat munie d'un ensemble de doigts sensibles mobiles, une électrode fixe par rapport audit substrat munie d'un ensemble de doigts sensibles fixes, chacun des doigts mobiles étant disposé entre deux doigts fixes contigus de manière à former une microstructure à peignes interdigités.

### ÉTAT DE LA TECHNIQUE ANTÉRIEURE

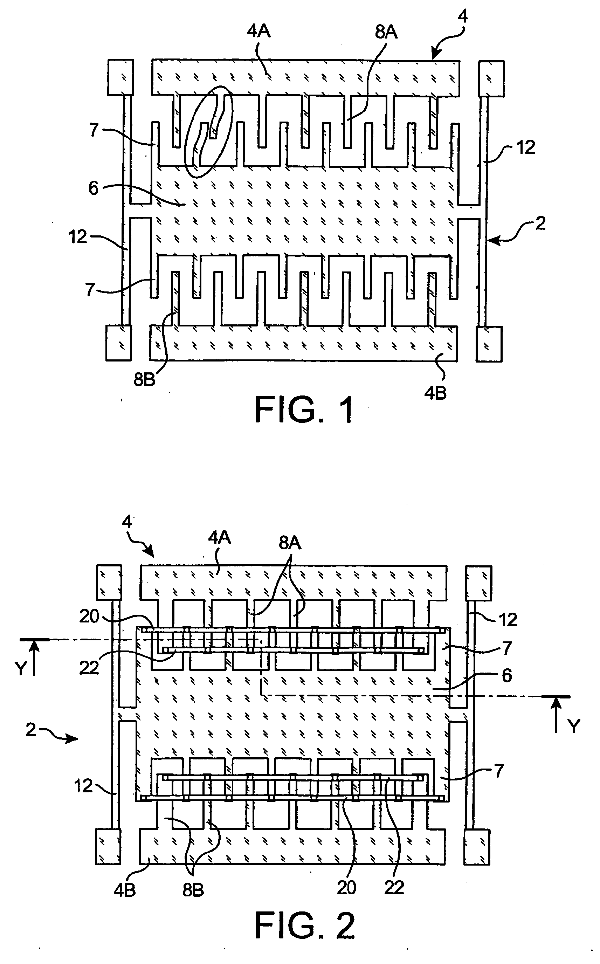

La figure 1 illustre schématiquement une vue de dessus d'un accéléromètre à peignes interdigités de l'art antérieur comportant une première électrode 2 et une deuxième électrode 4 gravées dans un même substrat en silicium 5. La première électrode 2 est constituée par une masse mobile 6 munie d'une pluralité de doigts mobiles 7 s'étendent latéralement. La deuxième électrode est composée de deux parties 4A, 4B situées de part et d'autre de la masse mobile 6 et comportant chacune plusieurs doigts fixes 8 s'étendant parallèlement aux doigts mobiles 7. Chacun des doigts mobiles 7 étant disposé entre deux doigts fixes contigus de manière à définir une microstructure à peignes interdigités. La masse mobile 6 est reliée au substrat 5 par une tige flexible 12 définissant un ressort de rappel.

En fonctionnement, sous l'effet d'une accélération suivant l'axe de la masse mobile 6, celle-ci se déplace dans le plan par rapport au substrat 5 entraînant un déplacement relatif des doigts mobiles 7 par rapport aux doigts fixes 8. Ce déplacement relatif produit une variation de la capacité entre les doigts mobiles 7 et les doigts fixes 8. La mesure d'accélération s'effectue par la mesure de cette variation de capacité.

Généralement, ces micro-accéléromètres sont réalisés soit sur une couche de silicium polycristallin déposée sur une couche sacrificielle d'oxyde, soit sur substrat de type SOI (Silicon On Insulator pour Silicium sur Isolant) comportant une couche d'oxyde enterrée servant alors de couche sacrificielle. Un exemple d'une telle microstructure est décrit dans le brevet français de la demanderesse N° FR2558263.

Un problème des accéléromètres de l'art antérieur décrits ci-dessus provient du fait que dans certaines conditions, les doigts mobiles et les doigts fixes restent collés les uns aux autres, comme cela est illustré à la figure 1, conduisant à une baisse sensible du rendement de fabrication, et à un risque important de dysfonctionnement de l'accéléromètre. Ce problème peut avoir pour origine l'accumulation de charges sur les surfaces des doigts sensibles et survient soit après un choc, soit après l'application d'une différence de potentiel entre peignes fixes et peignes mobiles susceptible de mettre les deux jeux d'électrodes en contact.

Pour remédier à ce problème, une solution connue consiste à solidariser les doigts des peignes par l'utilisation d'une couche sacrificielle épaisse sur les doigts de la structure et le dépôt d'une couche, si possible non contrainte, typiquement du Si polycristallin, pour relier ces doigts.

Cette solution est complexe car, d'une part, l'obtention d'une couche sacrificielle épaisse est difficile, et d'autre part, l'utilisation d'une couche non contrainte limite le choix du matériau et nécessite l'utilisation d'un procédé haute température.

Le document « Patent Abstract of Japan, vol. 1998, n°05 du 30 avril 1998 » décrit un accéléromètre capacitif comportant une électrode mobile et un circuit de traitement agencés sur une première couche de silicium, ladite électrode mobile étant séparée d'une deuxième couche de silicium par un espace de sorte que la capacité entre l'électrode mobile et la deuxième couche de silicium décroît lorsque l'électrode mobile se déplace.

Le document DE 199 28 291-A1 décrit un accéléromètre comportant une masse centrale ancrée de façon flexible sur un substrat, une pluralité de doigts formés dans la masse centrale et s'étendant en vis-à-vis du substrat. Ladite masse centrale et lesdits doigts n'étant pas en contact avec le substrat.

Le but de l'invention est de pallier les inconvénients de l'art antérieur décrits ci-dessus.

### EXPOSÉ DE L'INVENTION

L'invention préconise un accéléromètre à peignes capacitifs comportant un substrat, une électrode mobile par rapport audit substrat munie d'un ensemble de doigts mobiles, une électrode fixe par rapport audit substrat munie d'un ensemble de doigts fixes, chacun desdits doigts mobiles étant disposé entre deux doigts fixes contigus de manière à former une microstructure à peignes interdigités.

Selon l'invention, les doigts mobiles sont solidarisés entre eux par au moins une première poutre de liaison gravée directement dans le substrat, et/ou, les doigts fixes sont solidarisés entre eux par au moins une deuxième poutre de liaison gravée directement dans le substrat.

Préférentiellement, lesdites poutres de liaison sont situées à proximité de l'extrémité des doigts à solidariser.

Cette disposition permet d'augmenter la raideur de l'ensemble des doigts mobiles et/ou des doigts fixes dans la zone à fort déplacement des doigts mobiles.

Avantageusement, l'électrode mobile est reliée au substrat par des tiges flexibles. Préférentiellement, les tiges flexibles sont réalisées aux extrémités de l'électrode mobile. Avantageusement, ces tiges flexibles sont gravées directement dans le substrat.

Dans un mode préféré de réalisation, l'électrode mobile comporte une masse mobile, de préférence rectangulaire, à partir de laquelle s'étendent latéralement lesdits doigts mobiles, et l'électrode fixe comporte deux parties disposées symétriquement de part et d'autre de la masse mobile et comportant chacune des doigts fixes s'étendant latéralement vers ladite masse mobile de sorte que chaque doigt mobile soit disposé entre deux doigts fixes contigus.

Avantageusement, la masse mobile comporte au moins une poutre de liaison gravée dans le substrat. L'épaississement local de la masse mobile à pour effet d'augmenter la sensibilité de l'accéléromètre sans augmenter sa taille.

Dans un mode avantageux de l'invention, les doigts mobiles et/ou les doigts fixes situés aux extrémités de la masse mobile présentent une largeur supérieure à celle des autres doigts mobiles et/ou fixes. Ceci permet d'augmenter la raideur de l'ensemble des doigts sans limiter leur nombre.

Préférentiellement, le substrat est un substrat SOI.

L'accéléromètre selon l'invention est réalisé par un procédé comportant les étapes suivantes :
- fourniture d'un substrat comportant une couche sacrificielle enterrée,
- formation d'un masque sur une face du substrat selon un motif pour définir une microstructure à peignes interdigités comprenant une masse sismique, des ressorts de rappel, un ensemble de doigts mobiles et un ensemble de doigts fixes agencés de telle sorte que chaque doigt mobile soit disposé entre deux doigts fixes contigus,
- gravure dans la face du substrat selon le motif avec arrêt sur la couche sacrificielle enterrée,
- fourniture d'un substrat support présentant une cavité sur une de ses faces,
- scellement de la face du substrat comprenant la microstructure à peignes interdigités sur la face du substrat support en vis-à-vis de la cavité dudit substrat support.
- amincissement de la face du substrat exposée, avec arrêt avant la couche sacrificielle enterrée selon une épaisseur au moins égale à l'épaisseur de la au moins une poutre de liaison,
- formation de la au moins une première poutre de liaison reliant les doigts mobiles, et/ou de la au moins une deuxième poutre de liaison reliant les doigts fixes par gravure dans la face du substrat exposée avec arrêt sur la couche sacrificielle,
- formation de points d'ancrage servant à ancrer la au moins une première poutre de liaison sur au moins deux doigts mobiles, et/ou la au moins une deuxième poutre de liaison sur au moins deux doigts fixes,
- élimination d'au moins une partie de la couche sacrificielle pour désolidariser l'ensemble de doigts mobiles de l'ensemble de doigts fixes.

Il est préférable qu'il y ait au moins deux points d'ancrage par poutre de liaison.

Avantageusement, l'amincissement est réalisé par gravure, par exemple par gravure plasma (DRIE), par gravure mixte KOH et DRIE, par amincissement mécanique.

L'élimination de la couche sacrificielle est réalisée avantageusement par gravure humide ou par gravure avec de l'acide fluorhydrique sous forme vapeur.

Selon une variante, le procédé comprend en outre une étape de formation d'au moins une poutre de liaison sur la masse mobile et une étape de formation de points d'ancrage servant à ancrer ladite au moins une poutre de liaison sur la masse mobile.

Avantageusement, l'étape de formation de points d'ancrage peut être réalisée avant l'étape de formation de la au moins une poutre de liaison.

Préférentiellement, le substrat est un substrat SOI, c'est-à-dire un substrat de silicium comportant une couche sacrificielle enterrée de SiO₂.

Préférentiellement, les points d'ancrage des poutres de liaison sont en un matériau choisi parmi SiN, Si₃N₄ et le silicium polycristallin.

Avantageusement, l'étape de formation des points d'ancrage est obtenue en réalisant des trous par gravure de la face exposée du substrat et de la couche sacrificielle sous-jacente et en remplissant ces trous par le matériau des points d'ancrage. Les points d'ancrage peuvent par exemple être réalisés par lithogravure de la couche supérieure du substrat et de la couche sacrificielle jusqu'à atteindre la couche inférieure du substrat sous-jacente à la couche sacrificielle.

Selon une variante, l'étape de scellement peut être réalisé par exemple par adhésion moléculaire, scellement eutectique, polymère...

Avantageusement, le substrat support est en silicium ou en verre. Le substrat support sert de support mécanique.

### BRÈVE DESCRIPTION DES DESSINS

D'autres caractéristiques et avantages de l'invention ressortiront de la description qui suit, prise à titre d'exemple non limitatif, en référence aux figures annexées dans lesquelles :
- la figure 1, décrite précédemment, illustre schématiquement une vue de dessus d'un accéléromètre de l'art antérieur,
- la figure 2 illustre schématiquement une vue de dessus d'un accéléromètre selon l'invention,
- les figures 3 à 11 sont des vues en coupe verticale selon l'axe YY de la figure 2, illustrant schématiquement les différentes phases du procédé de réalisation d'un accéléromètre selon l'invention.

### EXPOSÉ DÉTAILLÉ DE MODES DE RÉALISATION PARTICULIERS

Dans la suite de la description, les éléments communs aux dispositifs de l'art antérieur et aux dispositifs de l'invention seront désignés par des références identiques.

La figure 2 illustre schématiquement une vue de dessus d'un accéléromètre micro-usiné à peignes capacitifs réalisé dans un substrat 5 de type SOI (pour Silicon on insulator, Silicium sur Isolant) et reporté sur une cavité.

Cet accéléromètre comporte une première électrode 2 mobile par rapport au substrat 5 et une deuxième électrode (4A, 4B) fixe par rapport audit substrat 5. L'électrode mobile 2 comporte une masse mobile 6 de forme rectangulaire, gravée dans le substrat 5et munie d'un ensemble de doigts sensibles 7 également gravés dans le substrat 5 et s'étendant latéralement sur chaque côté de la masse mobile 6.

L'électrode fixe 4 comporte une première partie 4A agencée le long d'un des côtés de la masse mobile 6, et une deuxième partie 4B agencée le long de l'autre côté de la masse mobile 6.

La première partie 4A et la deuxième partie 4B comportent chacune plusieurs doigts fixes 8A, 8B s'étendant latéralement en direction de la masse mobile 6 et parallèlement aux doigts mobiles 7 de sorte que chaque doigt mobile 7 soit disposé entre deux doigts fixes contigus 8.

La masse mobile 6 est reliée à l'électrode fixe (4A, 4B) au moyen de tiges flexibles 12 réalisées par gravure dans le substrat 5.

Dans le mode de réalisation illustré par la figure 2, les doigts mobiles 7 sont reliés entre eux par une première poutre de liaison 20 réalisée par gravure dans la masse du substrat (partie massive du substrat). De même, les doigts fixes (8A, 8B) sont reliés entre eux par une deuxième poutre de liaison 22 réalisée par gravure dans la masse du substrat (partie massive du substrat).

La première poutre de liaison 20 est ancrée sur chaque doigt mobile 7 et la deuxième poutre de liaison 22 est ancrée sur chaque doigt fixe (8A, 8B).

L'encrage des poutres de liaison 20, 22 peut être obtenu par dépôt type Si₃N₄ ou Silicium polycristallin.

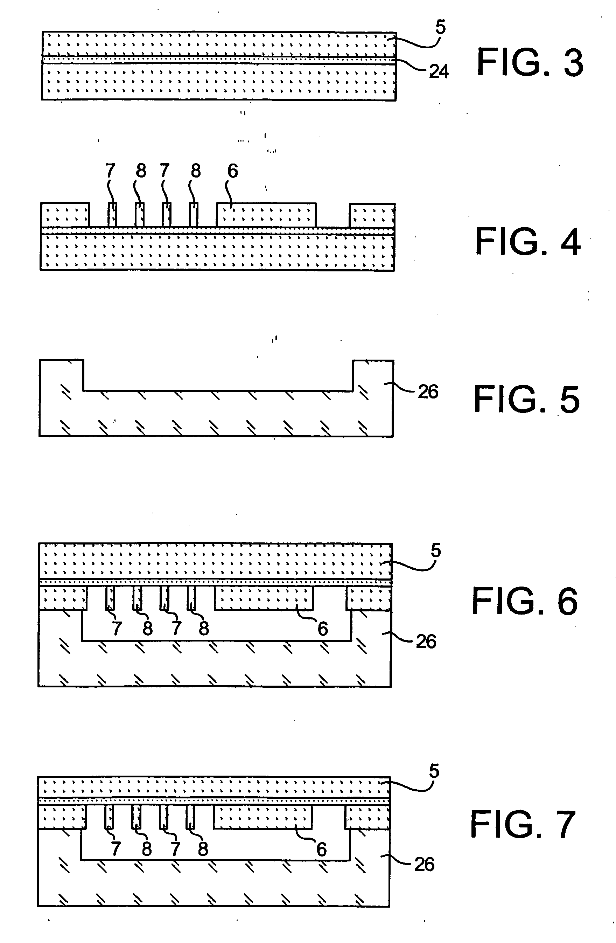

Le substrat 5 comporte une couche d'oxyde enterré (visible sur la figure 3 représentant le substrat 5) qui joue le rôle de couche sacrificielle aux poutres de liaison définissant, après son retrait, un évidement permettant d'éviter que la poutre de liaison 20 (respectivement 22) des doigts mobiles (respectivement fixes) ne touchent les doigts fixes (respectivement mobiles).

Pour réaliser l'encrage des poutres 20 et 22, on peut également jouer sur les temps de gravure de la couche sacrificielle 24. En effet, si les poutres 20 et 22 sont nettement plus étroites que les zones d'encrage, lors de l'étape du retrait de la couche sacrificielle 24, celles-ci seront libérées bien avant que l'oxyde au niveau de l'encrage ne disparaisse.

A titre d'exemple de réalisation, les poutres de liaison 20, 22 peuvent présenter une largeur de 2 µm et la zone d'encrage une largeur de 6 µm de côté. Cette variante permet la suppression de l'étape de dépôt.

Afin d'augmenter la raideur de l'ensemble, les doigts 7 situés aux deux extrémités de la masse mobile 6 sont élargis par rapport aux autres doigts. En outre, dans une variante de réalisation, l'épaisseur du silicium utilisé pour réaliser les poutres de liaison 20, 22, est conservée au niveau de la masse mobile 6 pour augmenter localement son épaisseur et donc sa masse. Cette variante permet d'augmenter la sensibilité du capteur dans la mesure où les ressorts de rappel restent inchangés, seule la masse augmente.

Pour assurer un bon encrage de la masse additionnelle sur la masse mobile 6, on ajoute des points d'encrage (en Si₃N₄ ou en Silicium polycristallin) comme pour les poutres de liaison 20, 22.

Une autre méthode consiste à choisir des dimensions de la zone de recouvrement de la masse mobile 6 et d'une masse additionnelle suffisantes pour que tout l'oxyde enterré ne s'élimine pas lors du retrait de la couche sacrificielle 24.

Le procédé de fabrication de l'accéléromètre selon l'invention va maintenant être décrit en référence aux figures 3 à 11 représentant une coupe verticale partielle de l'accéléromètre représenté à la figure 2, selon l'axe YY.

L'étape illustrée par la figure 3 consiste à réaliser un masque sur le substrat 5 de type SOI pour définir sur ce substrat la masse sismique, les ressorts de rappel, les zones d'ancrage, un ensemble de doigts mobiles et un ensemble de doigts fixes agencés de telle sorte que chaque doigt mobile soit disposé entre deux doigts fixes contigus. Comme on peut le voir sur cette figure, le substrat 5 comporte une couche d'oxyde sacrificielle (SiO₂) 24 enterrée.

L'étape illustrée par la figure 4 consiste à réaliser l'ensemble de doigts mobiles et l'ensemble de doigts fixes par gravure directe de 60 µm dans le substrat 5 SOI, avec arrêt sur la couche d'oxyde enterrée (SiO₂) 24.

L'étape illustrée par la figure 5 consiste à graver une cavité de 30pm sur un deuxième substrat 26 en Silicium.

L'étape illustrée par la figure 6 consiste à sceller le substrat SOI 5 sur le deuxième substrat 26, par exemple par adhésion moléculaire, scellement eutectique, polymère...

L'étape illustrée par la figure 7 consiste à amincir le substrat SOI par gravure, par exemple par gravure plasma (DRIE), par gravure mixte KOH et DRIE, par amincissement mécanique, avec arrêt à environ 10µm de la couche d'oxyde enterrée (SiO₂) 24.

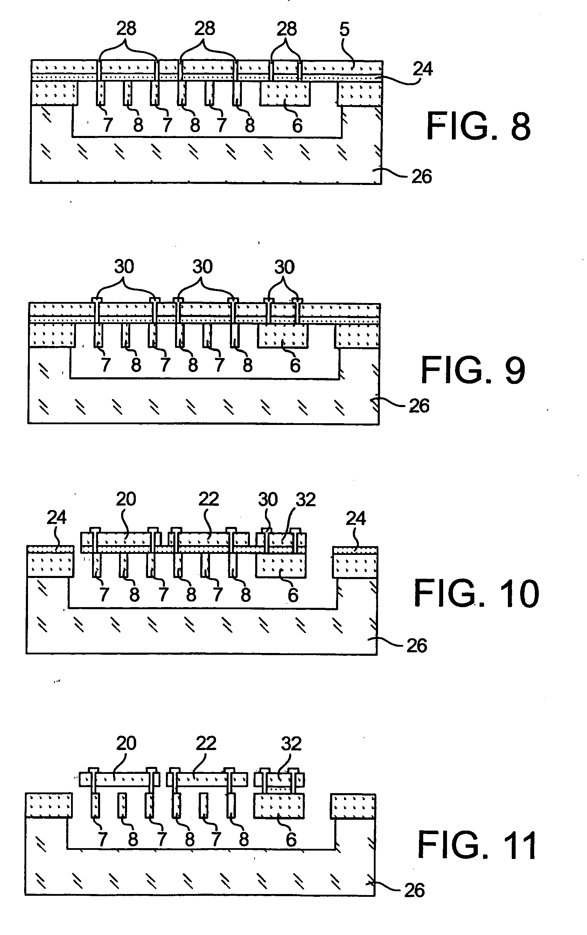

L'étape illustrée par la figure 8 consiste à réaliser, par lithogravure, des points d'encrage 30 des poutres de liaisons 20, 22 à 10 µm du silicium et 0,4 µm de la couche d'oxyde SiO₂ 24 jusqu'à atteindre la couche de silicium « du dessous ».

L'étape illustrée par la figure 9 consiste à effectuer un dépôt 30 d'environ 0,8 µm de Si₃N₄ et une lithogravure des points d'encrage des poutre de liaison sur les doigts 20, 22.

L'étape illustrée par la figure 10 consiste à réaliser la poutre de liaison 20 reliant les doigts mobiles 7 et la poutre de liaison 22 reliant les doigts fixes 8, ainsi que la poutre de liaison 32 sur la masse mobile 6.

L'étape illustrée par la figure 11 consiste à retirer la couche sacrificielle 24 par gravure humide ou par gravure HF (pour acide fluorhydrique) vapeur pour désolidariser l'ensemble de doigts mobiles de l'ensemble de doigts fixes.

Ce procédé permet :
- d'éliminer le problème de collage des peignes interdigités,
- de s'affranchir de l'utilisation d'une couche sacrificielle déposée,
- d'obtenir des poutres de liaison directement dans le substrat, donc en silicium monocristallin, évitant ainsi les contraintes mécaniques sur les peignes susceptibles de déformer les doigts.

En outre, avec le procédé selon l'invention, il est possible d'épaissir localement certaines parties de la masse mobile afin d'augmenter la sensibilité sans augmenter la taille de l'accéléromètre.

## Revendications

1. Accéléromètre à peignes capacitifs comportant un substrat (5), une électrode mobile (2) par rapport audit substrat (5) munie d'un ensemble de doigts mobiles (7), une électrode (4) fixe par rapport audit substrat (5) munie d'un ensemble de doigts fixes (8A, 8B), chacun desdits doigts mobiles (7) étant disposé entre deux doigts fixes contigus (8A, 8B) de manière à former une microstructure à peignes interdigités, **caractérisé en ce que** les doigts mobiles (7) sont solidarisés entre eux par au moins une première poutre de liaison (20) gravée directement dans le substrat (5), et/ou, les doigts fixes (8A, 8B) sont solidarisés entre eux par au moins une deuxième poutre de liaison (22) gravée directement dans le substrat (5).

2. Accéléromètre selon la revendication 1, dans lequel lesdites poutres de liaison (20, 22) sont situées à proximité de l'extrémité des doigts à solidariser.

3. Accéléromètre selon la revendication 1, dans lequel l'électrode mobile (2) est reliée au substrat par des tiges flexibles (12).

4. Accéléromètre selon la revendication 3, dans lequel lesdites tiges flexibles (12) sont gravées directement dans le substrat (5).

5. Accéléromètre selon l'une des revendications 1 à 4, dans lequel l'électrode mobile (2) comporte une masse mobile (6), à partir de laquelle s'étendent latéralement lesdits doigts mobiles (7), et l'électrode fixe (4) comporte deux parties (4A, 4B) disposées symétriquement de part et d'autre de la masse mobile (6) et comportant chacune des doigts fixes (8A, 8B) s'étendant latéralement vers ladite masse mobile (6) de sorte que chaque doigt mobile (7) soit disposé entre deux doigts fixes (8A, 8B) contigus.

6. Accéléromètre selon la revendication 5, dans lequel la masse mobile (6) comporte au moins une poutre de liaison gravée dans le substrat (5).

7. Accéléromètre selon la revendication 5 ou 6, dans lequel les doigts mobiles (7) et/ou les doigts fixes (8A, 8B) situés aux extrémités de la masse centrale (6) présentent une largeur supérieure à celle des autres doigts mobiles et/ou fixes.

8. Accéléromètre selon l'une quelconque des revendications 1 à 7, dans lequel le substrat (5) est un substrat SOI.

9. Procédé de fabrication d'un accéléromètre à peignes capacitifs **caractérisé en ce qu'**il comporte les étapes suivantes :
- fourniture d'un substrat (5) comportant une couche sacrificielle enterrée (24),
- formation d'un masque sur une face du substrat (5) selon un motif pour définir une microstructure à peignes interdigités comprenant une masse sismique (6), des ressorts de rappel (12), un ensemble de doigts mobiles (7) et un ensemble de doigts fixes (8A, 8B) agencés de telle sorte que chaque doigt mobile (7) soit disposé entre deux doigts fixes (8A, 8B) contigus,
- gravure dans la face du substrat (5) selon le motif avec arrêt sur la couche sacrificielle enterrée (24),
- fourniture d'un substrat support (26) présentant une cavité sur une de ses faces,
- scellement de la face du substrat (5) comprenant la microstructure à peignes interdigités sur la face du substrat support (26) en vis-à-vis de la cavité dudit substrat support.
- amincissement de la face du substrat (5) exposée, avec arrêt avant la couche sacrificielle enterrée selon une épaisseur au moins égale à l'épaisseur de la au moins une poutre de liaison (20, 22),
- formation de la au moins une première poutre de liaison (20) reliant les doigts mobiles (7), et/ou de la au moins une deuxième poutre (22) de liaison reliant les doigts fixes (8A, 8B) par gravure dans la face du substrat (5) exposée avec arrêt sur la couche sacrificielle,
- formation de points d'ancrage (30) servant à ancrer la au moins une première poutre de liaison (20) sur au moins deux doigts mobiles (7), et/ou la au moins une deuxième poutre (22) de liaison sur au moins deux doigts fixes (8A, 8B),
- élimination d'au moins une partie de la couche sacrificielle pour désolidariser l'ensemble de doigts mobiles (7) de l'ensemble de doigts fixes (8A, 8B).

10. Procédé de fabrication selon la revendication 9, comprenant en outre une étape de formation d'au moins une poutre de liaison sur la masse mobile (6) et une étape de formation de points d'ancrage (30) servant à ancrer ladite au moins une poutre de liaison sur la masse mobile.

11. Procédé de fabrication selon la revendication 9 ou 10, dans lequel l'étape de formation de points d'ancrage est réalisée avant l'étape de formation de la au moins une poutre de liaison.

12. Procédé de fabrication selon la revendication 9, dans lequel le substrat (5) est un substrat SOI, c'est-à-dire un substrat de silicium comportant une couche enterrée de SiO₂, la couche enterrée servant de couche sacrificielle.

13. Procédé de fabrication selon la revendication 11, dans lequel les points d'ancrage des poutres de liaison sont en un matériau choisi parmi SiN, Si₃N₄ et le silicium polycristallin.

14. Procédé de fabrication selon la revendication 11, dans lequel l'étape de formation des points d'ancrage est obtenue en réalisant des trous par gravure de la face exposée du substrat et de la couche sacrificielle sous-jacente et en remplissant ces trous par le matériau des points d'ancrage.

15. Procédé de fabrication selon la revendication 14, dans lequel le substrat support (26) est en silicium ou en verre.

## Claims

1. A comb capacitive accelerometer comprising a substrate (5), a mobile electrode (2) relative to said substrate (5) fitted with a set of mobile fingers (7), a fixed electrode (4) relative to said substrate (5) fitted with a set of fixed fingers (8A, 8B), each of said mobile fingers (7) being positioned between two contiguous fixed fingers (8A, 8B) so as to form a microstructure with interdigital combs, **characterised in that** the mobile fingers (7) are connected to one another by at least a first connecting beam (20) etched directly in the substrate (5), and/or, the fixed fingers (8A, 8B) are connected to one another by at least a second connecting beam (22) etched directly in the substrate (5).

2. The accelerometer according to Claim 1, in which said connecting beams (20, 22) are located in the vicinity of the end of the fingers to be joined.

3. The accelerometer according to Claim 1, in which the mobile electrode (2) is joined to the substrate by flexible rods (22).

4. The accelerometer according to Claim 3, in which said flexible rods (12) are etched directly into the substrate (5).

5. The accelerometer according to any one of Claims 1 to 4, in which the mobile electrode (2) comprises a mobile mass (6), from which extend laterally said mobile fingers (7), and the fixed electrode (4) comprises two parts (4A, 4B) positioned symmetrically on either side of the mobile mass (6) and each comprising fixed fingers (8A, 8B) extending laterally towards said mobile mass (6) such that each mobile finger (7) is positioned between two contiguous fixed fingers (8A, 8B).

6. The accelerometer according to Claim 5, in which the mobile mass (6) comprises at least one connecting beam etched into the substrate (5).

7. The accelerometer according to Claim 5 or 6, in which the mobile fingers (7) and/or the fixed fingers (8A, 8B) located at the ends of the central mass (6) have a width greater than that of the other mobile and/or fixed fingers.

8. The accelerometer according to any one of Claims 1 to 7, in which the substrate (5) is a SOT substrate.

9. A manufacturing process of a comb capacitive accelerometer **characterised in that** it comprises the following stages:
- providing a substrate (5) comprising a buried sacrificial layer (24),
- forming a mask on a face of the substrate (5) according to a pattern for defining a microstructure with interdigital combs comprising a seismic mass (6), return springs (12), a set of mobile fingers (7) and a set of fixed fingers (8A, 8B) arranged such that each mobile finger (7) is positioned between two contiguous fixed fingers (8A, 8B),
- etching in the face of the substrate (5) according to the pattern stopping on the buried sacrificial layer (24),
- providing a support substrate (26) with a cavity on one of its faces,
- sealing the face of the substrate (5) comprising the microstructure with interdigital combs on the face of the support substrate (26) vis-à-vis the cavity of said support substrate
- thinning of the face of the exposed substrate (5), stopping before the buried sacrificial layer according to a thickness at least equal to the thickness of at least one connecting beam (20, 22),
- forming at least one first connecting beam (20) joining the mobile fingers (7), and/or at least one second connecting beam (22) joining the fixed fingers (8A, 8B) by etching in the face of the exposed substrate (5) stopping on the sacrificial layer,
- forming anchoring points (30) for attaching at least a first connecting beam (20) on at least two mobile fingers (7), and/or at least a second connecting beam (22) on at least two fixed fingers (8A, 8B),
- eliminating least part of the sacrificial layer to separate the ensemble of mobile fingers (7) from the ensemble of fixed fingers (8A, 8B).

10. The manufacturing process according to Claim 9, additionally comprising a formation stage of at least one connecting beam on the mobile mass (6) and a formation stage of anchoring points (30) for attaching said at least one connecting beam on the mobile mass.

11. The manufacturing process according to Claim 9 or 10, in which the formation stage of anchoring points is completed prior to the formation stage of at least one connecting beam.

12. The manufacturing process according to Claim 9, in which the substrate (5) is an SOI substrate, that is, a silicon substrate comprising a buried layer of SiO₂, the buried layer acting as sacrificial layer.

13. The manufacturing process according to Claim 11, in which the anchoring points of the connecting beams are made of a material selected from SiN, Si₃N₄ and polycrystalline silicon.

14. The manufacturing process according to Claim 11, in which the formation stage of the anchoring points is completed by arranging holes by etching the exposed face of the substrate and the subjacent sacrificial layer and by filling these holes with the material of the anchoring points.

15. The manufacturing process according to Claim 14, in which the support substrate (26) is made of silicon or glass.

## Patentansprüche

1. Beschleunigungsmesser mit kapazitiven Kämmen, umfassend ein Substrat (5), eine Elektrode (2), die in Bezug auf das Substrat (5) beweglich ist und mit einer Anordnung beweglicher Finger (7) ausgestattet ist, eine in Bezug auf das Substrat (5) feste Elektrode (4), die mit einer Anordnung fester Finger (8A, 8B) ausgestattet ist, wobei jeder der beweglichen Finger (7) zwischen zwei festen aneinandergrenzenden Fingern (8A, 8B) derart angeordnet ist, dass eine Mikrostruktur mit Interdigitalkämmen gebildet ist, **dadurch gekennzeichnet, dass** die beweglichen Finger (7) miteinander durch wenigstens einen ersten Verbindungsträger (20) verbunden sind, der direkt in das Substrat (5) geätzt ist, oder/und die festen Finger (8A, 8B) miteinander durch wenigstens einen zweiten Verbindungsträger (22) verbunden sind, der direkt in das Substrat (5) geätzt ist.

2. Beschleunigungsmesser nach Anspruch 1, wobei sich die Verbindungsträger (20, 22) in der Nähe des Endes der zu verbindenden Finger befinden.

3. Beschleunigungsmesser nach Anspruch 1, wobei die bewegliche Elektrode (2) mit dem Substrat durch flexible Schäfte (12) verbunden ist.

4. Beschleunigungsmesser nach Anspruch 3, wobei die flexiblen Schäfte (12) direkt in das Substrat (5) geätzt sind.

5. Beschleunigungsmesser nach einem der Ansprüche 1 bis 4, wobei die bewegliche Elektrode (2) eine bewegliche Masse (6) umfasst, ausgehend von welcher sich seitlich die beweglichen Finger (7) erstrecken, und wobei die feste Elektrode (4) zwei Bereiche (4A, 4B) umfasst, welche symmetrisch beiderseits der beweglichen Masse (6) angeordnet sind und jeweils feste Finger (8A, 8B) umfassen, welche sich seitlich zu der beweglichen Masse (6) hin derart erstrecken, dass jeder bewegliche Finger (7) zwischen zwei festen aneinandergrenzenden Fingern (8A, 8B) angeordnet ist.

6. Beschleunigungsmesser nach Anspruch 5, wobei die bewegliche Masse (6) wenigstens einen Verbindungsträger umfasst, welcher in das Substrat (5) geätzt ist.

7. Beschleunigungsmesser nach Anspruch 5 oder 6, wobei die beweglichen Finger (7) oder/und die festen Finger (8A, 8B), welche sich an den Enden der zentralen Masse (6) befinden, eine Breite aufweisen, die größer als die Breite der anderen beweglichen oder/und festen Finger ist.

8. Beschleunigungsmesser nach einem der Ansprüche 1 bis 7, wobei das Substrat (5) ein SOI-Substrat ist.

9. Verfahren zur Herstellung eines Beschleunigungsmessers mit kapazitiven Kämmen, **dadurch gekennzeichnet, dass** es die folgenden Schritte umfasst:
- Bereitstellen eines Substrats (5), welches eine eingebettete Opferschicht (24) umfasst,
- Bilden einer Maske auf einer Seite des Substrats (5) gemäß einem Motiv zur Definition einer Mikrostruktur mit Interdigitalkämmen, welche eine seismische Masse (6), Rückstellfedern (12), eine Anordnung beweglicher Finger (7) und eine Anordnung fester Finger (8A, 8B) umfasst, welche derart angeordnet sind, dass jeder bewegliche Finger (7) zwischen zwei festen aneinandergrenzenden Fingern (8A, 8B) angeordnet ist,
- gemäß dem Motiv Ätzen in die Seite des Substrats (5) mit Einhalt an der eingebetteten Opferschicht (24),
- Bereitstellen eines Trägersubstrats (26), das eine Kavität an einer seiner Seiten aufweist,
- Versiegeln der Seite des Substrats (5), welche die Mikrostruktur mit Interdigitalkämmen umfasst auf der Seite des Trägersubstrats (26) gegenüber der Kavität des Trägersubstrats,
- Verdünnen der ausgesetzten Seite des Substrats (5) mit Einhalt vor der eingebetteten Opferschicht gemäß einer Dicke, welche wenigstens genauso groß ist wie die Dicke des wenigstens einen Verbindungsträgers (20, 22),
- Bilden des wenigstens einen ersten Verbindungsträgers (20), welcher die beweglichen Finger (7) verbindet, oder/und des wenigstens einen zweiten Verbindungsträgers (22), welcher die festen Finger (8A, 8B) verbindet, durch Ätzen in die ausgesetzte Seite des Substrats (5) mit Einhalt an der Opferschicht,
- Bilden von Verankerungspunkten (30), welche dazu dienen, den wenigstens einen ersten Verbindungsträger (20) an wenigstens zwei beweglichen Fingern (7) zu verankern, oder/und den wenigstens einen zweiten Verbindungsträger (22) an wenigstens zwei festen Fingern (8A, 8B) zu verankern,
- Eliminieren wenigstens einen Bereichs der Opferschicht, um die Anordnung von beweglichen Fingern (7) von der Anordnung von festen Fingern (8A, 8B) zu trennen.

10. Herstellungsverfahren nach Anspruch 9, ferner umfassend einen Schritt zur Bildung wenigstens eines Verbindungsträgers an der beweglichen Masse (6) und einen Schritt zur Bildung von Verankerungspunkten (30), welche dazu dienen, den wenigstens einen Verbindungsträger an der beweglichen Masse zu verankern.

11. Herstellungsverfahren nach Anspruch 9 oder 10, wobei der Schritt zur Bildung von Verankerungspunkten vor dem Schritt zur Bildung des wenigstens einen Verbindungsträgers durchgeführt wird.

12. Herstellungsverfahren nach Anspruch 9, wobei das Substrat (5) ein SOI-Substrat ist, das bedeutet, ein Siliziumsubstrat, welches eine eingebettete SiO₂-Schicht umfasst, wobei die eingebettete Schicht als Opferschicht dient.

13. Herstellungsverfahren nach Anspruch 11, wobei die Verankerungspunkte der Verbindungsträger aus einem aus SiN, Si₃N₄ und polykristallinem Silizium ausgewählten Material gebildet sind.

14. Herstellungsverfahren nach Anspruch 11, wobei der Schritt zur Bildung der Verankerungspunkte durch Bilden von Löchern durch Ätzen der ausgesetzten Seite des Substrats und der darunterliegenden Opferschicht und durch Füllen dieser Löchern mit dem Material der Verankerungspunkte erhalten wird.

15. Herstellungsverfahren nach Anspruch 14, wobei das Trägersubstrat (26) aus Silizium oder aus Glas ist.
